# EUROPEAN PATENT APPLICATION

(11) **EP 2 043 174 A1**
(43) Date of publication of application: **01.04.2009**
(21) Application number: 08253107.0
(22) Date of filing: 23.09.2008
(51) Int. Cl.: H01L 51/50

(54) **Organic light emitting device**

(30) Priority: 28.09.2007 KR 20070098380
(71) Applicant: Samsung Mobile Display Co., Ltd., Suwon-si Gyeonggi-do (KR)
(72) Inventor: Song, Won-Jun , Samsung SDI Co., Ltd., Gyeonggi-do (KR); Sung, Yeun-Joo , Samsung SDI Co., Ltd., Gyeonggi-do (KR); Choi, Keon-Ha , Samsung SDI Co., Ltd., Gyeonggi-do (KR); Lee, Sun-Hee , 3th Floor, Koryo Building, Seoul (KR); Kim, Mu Hyun , Samsung SDI Co., Ltd., Gyeonggi-do (KR)
(74) Representative: Mounteney, Simon James

(57) **Abstract**

An organic light emitting device includes a first electrode; a second electrode; an emitting layer interposed between the first electrode and the second electrode; and a hole injection layer interposed between the first electrode and the emitting layer. The hole injection layer includes a first compound having an element selected from the group consisting of Mo, Li, Na, K, Rb, Cs, Be, Mg, Ca, Sr, Ba, and B and an element selected from the group consisting of O, F, S, Cl, Se, Br, and I; and a second compound that is an organic hole injection layer forming compound. These compounds have excellent electrical properties, and are suitable for a fluorescent and phosphorescent device emitting light of a full range of colors, such as red, green, blue, or white. Therefore, an organic light emitting device including the hole injection layer exhibits a high efficiency and high luminance at low voltage, and has a long lifetime.

## Description

Aspects of the present invention relate to an organic light emitting device, and more particularly, to an organic light emitting device having a high luminance efficiency and a long lifetime.

Aspects of the present invention relate to developing an organic light emitting device having high quality, and specifically, relate to an organic light emitting device having a low power consumption and a long lifetime.

Organic light emitting devices generate light by recombination of electrons and holes in an organic layer placed between electrodes when a current is provided to the organic layer. Therefore, organic light emitting devices can be used to provide thin light-weight information display apparatuses having a high image quality, quick response speed, and wide viewing angle. Due to such advantages, organic light emitting display devices have been quickly developed for a wide range of applications including mobiles and high-end information display apparatuses.

Such rapid development of organic light emitting devices has lead to increased competition with other information display devices, such as TFT-LCDs, in academic and technological fields. However, several problems of organic light emitting devices, such as low efficiency, short lifetime, and high power consumption, should be addressed in order to mass produce organic light emitting devices having high quality.

Aspects of the present invention provide an organic light emitting device having a high efficiency, low voltage, high brightness, and long lifetime, the device including an organic layer that includes a material for a hole injection layer, wherein the material has excellent electrical properties suitable for fluorescent and phosphorescent light emitting devices emitting light of a full range of colors, such as red, green, blue, and white.

According to the present invention there is provided an organic light emitting device as claimed in claim 1. Preferred features are set out in claims 2 to 10.

According to an embodiment of the present invention, there is provided an organic light emitting device including: a first electrode; a second electrode; an emitting layer interposed between the first electrode and the second electrode; and a hole injection layer interposed between the first electrode and the emitting layer, wherein the hole injection layer includes: a first compound having an element selected from the group consisting of Mo, Li, Na, K, Rb, Cs, Be, Mg, Ca, Sr, Ba, and B and an element selected from the group consisting of O, F, S, Cl, Se, Br, and I; and a second compound that is an organic compound for forming a hole injection layer.

According to an embodiment, the mixture ratio of the first compound to the second compound is in the range from 1:1 to 3:1.

According to another embodiment of the present invention, there is provided an organic light emitting device including: a first electrode; a second electrode; an emitting layer interposed between the first electrode and the second electrode; a first hole injection layer interposed between the first electrode and the emitting layer, wherein the hole injection layer includes: a first compound having an element selected from the group consisting of Mo, Li, Na, K, Rb, Cs, Be, Mg, Ca, Sr, Ba, and B and an element selected from the group consisting of O, F, S, Cl, Se, Br, and I; and a second compound that is an organic compound for forming a hole injection layer. The organic light emitting device according to the preferred embodiment further includes a second hole injection layer.

According to an embodiment, the thickness ratio of the first hole injection layer to the second hole injection layer is in the range from 1:99 to 1:9.

The material used to form the hole injection layer has preferably excellent electrical properties and is suitable for fluorescent and phosphorescent light emitting devices emitting light of a full range of colors, such as red, green, blue, and white. Therefore, an organic light emitting device including the hole injection layer has a high efficiency, low voltage, high brightness, and a long lifetime.

These and/or other aspects and advantages of the invention will become apparent and more readily appreciated from the following description of the embodiments, taken in conjunction with the accompanying drawings of which:
FIGS. 1A through 1D are sectional views of organic light emitting devices according to embodiments of the present invention;
FIG. 2A illustrates an energy band diagram schematically showing a difference between HOMO and LUMO levels of layers of an organic light emitting device according to the embodiment of FIG. 1A;
FIG. 2B illustrates an energy band diagram schematically showing a difference between HOMO and LUMO levels of layers of an organic light emitting device according to the embodiment of FIG. 1D;
FIG. 3 is a graph showing the efficiency properties of an organic light emitting device according to the Example and a conventional organic light emitting device according to the Comparative Example;
FIG. 4 is a graph showing brightness with respect to voltage of an organic light emitting device according to the Example and a conventional organic light emitting device according to the Comparative Example; and
FIG. 5 is a graph showing the brightness with respect to time of an organic light emitting device according to the Example and a conventional organic light emitting device according to the Comparative Example.

Reference will now be made in detail to the preferred embodiments of the present invention, examples of which are illustrated in the accompanying drawings, wherein like reference numerals refer to like elements throughout. The embodiments are described below in order to explain the present invention by referring to the figures.

An organic light emitting device according to a preferred embodiment of the present invention includes a first electrode; a second electrode; an emitting layer interposed between the first electrode and the second electrode; and a hole injection layer between the first electrode and the emitting layer. The hole injection layer includes a first compound and a second compound, wherein the first compound has an element selected from the group consisting of Mo, Li, Na, K, Rb, Cs, Be, Mg, Ca, Sr, Ba, and B and an element selected from the group consisting of O, F, S, Cl, Se, Br, and I, and the second compound is an organic compound suitable for forming a hole injection layer.

As non-limiting examples, the first compound can be molybdenum oxide, magnesium fluoride, magnesium oxide, lithium fluoride, sodium fluoride, calcium oxide, cesium fluoride, boron oxide, strontium oxide, or barium oxide. The first compound can be prepared using various known methods.

The second compound can be an organic compound that is known in the art to form a hole injection layer. For example, the second compound can be copper phthalocyanine, 1,3,5-tricarbazolylbenzene, 4,4'-biscarbazolylbiphenyl, polyvinylcarbazole, m-biscarbazolylphenyl, 4,4'-biscarbazolyl-2,2'-dimethylbiphenyl, 4,4',4"-tri(N-carbazolyl)triphenylamine (TCTA), 4,4',4"-tris(3-methylphenylamino)triphenylamine(m-MTDATA), 1,3,5-tri(2-carbazolylphenyl)benzene, 1,3,5-tris(2-carbazolyl-5-methoxyphenyl)benzene, bis(4-carbazolylphenyl)silane, N,N'-bis(3-methylphenyl)-N,N'-diphenyl-[1,1-biphenyl]-4,4'diamine (TPD), N,N'-di(naphthalene-1-yl)-N,N'-diphenyl benzidine (α-NPD), N,N'-diphenyl-N,N'-bis(1-naphthyl)-(1,1'-biphenyl)-4,4'-diamine (NPB), poly(9,9-dioctylfluorene-co-N-(4-butylphenyl)diphenylamine) (TFB), or poly(9,9-dioctylfluorene-co-bis-N,N-phenyl-1,4-phenylenediamine (PFB).

The first compound and the second compound can be mixed together in a mixture ratio of 1:1 to 3:1. When the mixture ratio of the first compound to the second compound is less than 1:1, such that the amount of the first compound is relatively low and the amount of the second compound is relatively high, the injection voltage may increase. On the other hand, when the mixture ratio of the first compound to the second compound is greater than 3:1 such that the amount of the first compound is relatively high and the amount of the second compound is relatively low, the conductivity properties of the first hole injection layer may be substantially increased and a current leakage may occur.

In general, a pure organic material is used to lower the hole injection barrier, and in this case, the organic material is selected such that an energy gap between an electrode and an organic material is minimized. However, when the first compound is used at an electrode interface, the contact resistance can be reduced due to the metallic properties of an element selected from the group consisting of Mo, Li, Na, K, Rb, Cs, Be, Mg, Ca, Sr, Ba, and B.. Therefore, properties closer to an ohmic contact, which are properties of an electrode interface used in a semiconductor compound, can be obtained. In addition, dipole properties can be obtained according the electronegativity of the second compound, or a charge transfer complex (C.T. complex) can be formed by charge transfer and the electric conductivity can be increased.

Therefore, an organic light emitting device including the hole injection layer according to preferred embodiments of the present invention minimizes the shortening of the lifetime of the organic light emitting device and provides high current efficiency when the organic light emitting device is operated at a constant voltage.

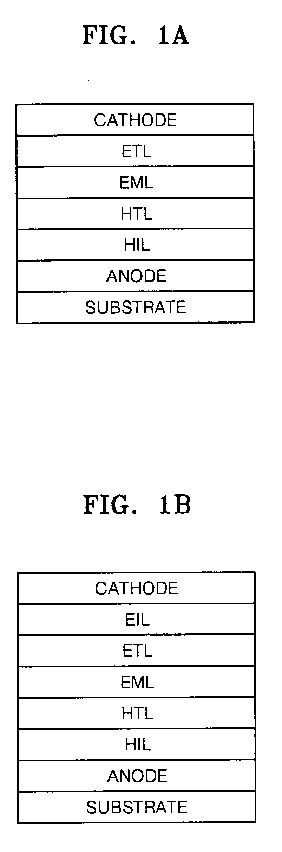

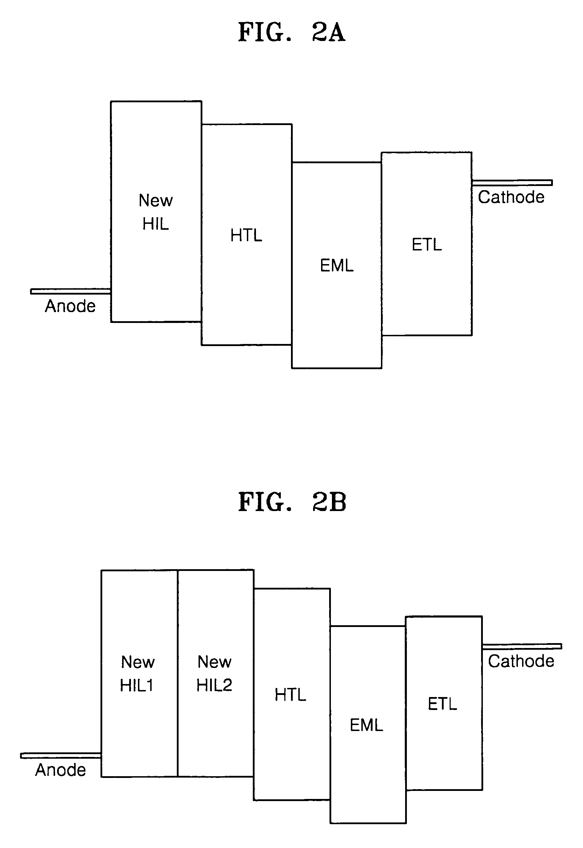

FIG. 2A illustrates an energy band diagram schematically showing a difference between HOMO and LUMO levels (that is, the energy level of the highest occupied molecular orbital (HOMO) and the energy level of the lowest unoccupied molecular orbital (LUMO), respectively) of layers of an organic light emitting device according to the embodiment of FIG. 1A.

The organic light emitting device according to preferred embodiments of the present invention described above can reduce a charge injection barrier and a contact resistance of an interface, and thus the organic light emitting device can operate for a longer period of time.

The organic light emitting device according to another embodiment of the present invention may further include a second hole injection layer.

The second hole injection layer can include any organic compound that is known in the art to form a hole injection layer. Such an organic compound for forming a hole injection layer can be copper phthalocyanine, 1,3,5-tricarbazolylbenzene, 4,4'-biscarbazolylbiphenyl, polyvinylcarbazole, m-biscarbazolylphenyl, 4,4'-biscarbazolyl-2,2'-dimethylbiphenyl, 4,4',4"-tri(N-carbazolyl)triphenylamine (TCTA), 4,4',4"-tris(3-methylphenylamino)triphenylamine(m-MTDATA), 1,3,5-tri(2-carbazolylphenyl)benzene, 1,3,5-tris(2-carbazolyl-5-methoxyphenyl)benzene, bis(4-carbazolylphenyl)silane, N,N'-bis(3-methylphenyl)-N,N'-diphenyl-[1,1-biphenyl]-4,4'diamine (TPD), N,N'-di(naphthalene-1-yl)-N,N'-diphenyl benzidine (α-NPD), N,N'-diphenyl-N,N'-bis(1-naphthyl)-(1,1'-biphenyl)-4,4'-diamine (NPB), poly(9,9-dioctylfluorene-co-N-(4-butylphenyl)diphenylamine) (TFB), or poly(9,9-dioctylfluorene-co-bis-N,N-phenyl-1,4-phenylenediamine (PFB). The second hole injection layer can be formed using at least one compound selected from the compounds described above.

When the hole injection layer of the organic light emitting device is a double layer including the first hole injection layer and the second hole injection layer, the effects described above can also be obtained. Specifically, when the second hole injection layer is further formed in addition to the first hole injection layer, an injection barrier of the first hole injection layer can be further lowered due to the second hole injection layer. Such an effect can be obtained since a decreased injection barrier of the first hole injection layer is dependent upon the energy level (HOMO) of the layer adjacent to the first hole injection layer.

The thickness ratio of the first hole injection layer and the second hole injection layer may be in the range from 1:99 to 1:9. When the thickness ratio of the first hole injection layer to the second hole injection layer is less than 1:99 such that the first hole injection layer is relatively much thinner than the second hole injection layer, the injection voltage may increase. On the other hand, when the thickness ratio of the first hole injection layer to the second hole injection layer is greater than 1:9 such that the first hole injection layer is relatively not much thinner than the second hole injection layer, the conductivity properties of the hole injection layer may substantially increase and a current leakage may occur.

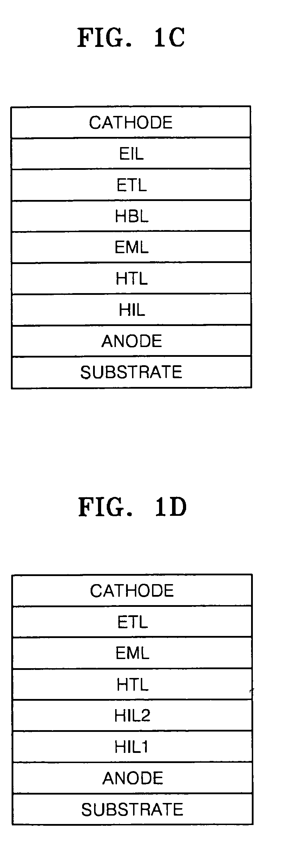

FIG. 2B illustrates an energy band diagram schematically showing a difference between HOMO and LUMO levels of layers of an organic light emitting device according to the embodiment of the present invention in which a hole injection layer is a double layer.
The organic light emitting device according to preferred embodiments of the present invention can have various structures. For example, the organic light emitting device can include the structures illustrated in FIGS. 1A through 1D, including a first electrode (for example, an anode), a hole injection layer (HIL), a hole transport layer (HTL), an emitting layer (EML), a hole blocking layer (HBL), an electron transport layer (ETL), an electron injection layer (EIL), and a second electrode (for example, a cathode). As non-limiting examples, the organic light emitting device may have one of the following structures:
first electrode/hole injection layer/hole transport layer/emitting layer/electron transport layer/second electrode (FIG. 1A);
first electrode/hole injection layer/hole transport layer/emitting layer/electron transport layer/electron injection layer/second electrode (FIG. 1 B);
first electrode/hole injection layer/hole transport layer/emitting layer/hole blocking layer/electron transport layer/electron injection layer/second electrode (FIG. 1 C); or
first electrode/first hole injection layer/second hole injection layer/hole transport layer/emitting layer/electron transport layer/second electrode (FIG. 1 D).

When desired, the organic light emitting device can further include one or two intermediate layers, such as a hole blocking layer that can be formed between the emitting layer and the electron transport layer and/or an electron blocking layer that can be formed between the emitting layer and the hole transport layer.

A method of fabricating the organic light emitting device according to a preferred embodiment will now be described in detail with reference to FIGS. 1A through 1D. First, a first electrode forming material that has a high work function is deposited on a substrate using a deposition method or a sputtering method in order to form a first electrode. The first electrode can be an anode. The substrate can be any substrate that is used in a conventional organic light emitting device. For example, the substrate can be a glass substrate that has high mechanical strength, high thermal stability, transparency, a planar surface, and easy handling properties, and is waterproof, or the substrate can be a transparent plastic substrate. The first electrode forming material can be a transparent material having excellent conductivity, such as indium tin oxide (ITO), indium zinc oxide (IZO), tin oxide (SnO₂), or zinc oxide (ZnO).

Then, a HIL can be formed using various known methods including a vacuum deposition method, a spin coating method, a casting method, or an LB method. Specifically, the HIL can be formed by co-depositing the first compound and the second compound.

When the HIL is formed using a vacuum deposition method, the deposition conditions may differ according to the material used to form the HIL and the structure and thermal properties of the HIL to be formed. For example, the deposition temperature may be in the range from 50 to 500°C, the vacuum degree may be in the range from 10⁻⁷ to 10⁻³ torr, the deposition speed may be in the range from 0.01 to 100Å/sec (0.001 to 10nm/sec), and the thickness of the layer formed may be in the range from 10Å (1 nm) to 5µm.

The material used to form the HTL can be any hole-transporting material known in the art. For example, the material used to form the HTL can be a carbazole derivative, such as N-phenylcarbazole or polyvinylcarbazole; a conventional amine derivative having an aromatic condensation ring, such as N,N'-bis(3-methylphenyl)-N,N'-diphenyl-[1,1-biphenyl]-4,4'-diamine(TPD) or N,N'-di(naphthalene-1-yl)-N,N'-diphenyl benzidine(α-NPD).

An EML that emits light of various colors can be formed on either the HIL or the HTL. The material used to form the EML is not limited, and can be any material selected from emitting layer materials known in the art, such as a known host material, and a known dopant material.

A red EML can be formed using, for example, DCM1, DCM2, Eu(thenoyltrifluoroacetone)₃ (Eu(TTA)₃) or butyl-6-(1,1,7,7,-tetramethyljulolidyl-9-enyl)-4H-pyran (DCJTB). Specifically, a red EML can be formed by doping DCJTB, which acts as a dopant, on Alq₃, or by co-depositing Alq₃ and rubrene and doping with a dopant. Alternatively, a red EML can be formed by doping BTPIᵣ or RD 61, which acts as a dopant, on 4,4'-N-N'- dicarbazole-biphenyl(CBP). However, the method of forming the red EML is not limited to the above method.

A green EML can be formed using, for example, coumarin 6, C545T, quinacridone, or Ir(ppy)₃. Specifically, a green EML can be formed by doping Ir(ppy)₃, which acts as a dopant, on CBP, or by doping Alq3, which acts as a host, on a coumarin-based material that acts as a dopant. However, the method of forming the green EML is not limited herein to the above method. As non-limiting examples, the coumarin-based material can be C314S, C343S, C7, C7S, C6, C6S, C314T, or C545T.

A blue EML can be formed using, for example, oxadiazole dimer dyes such as (Bis-DAPOXP), spiro compounds such as (Spiro-DPVBi, Spiro-6P), triarylamine compounds, bis(styryl) amine compounds such as (DPVBi, DSA), Flrpic, CzTT, anthracene, TPB, PPCP, DST, TPA, OXD-4, BBOT, AZM-Zn, or BH-013X (Idemitz Co.), which is an aromatic hydrocarbon compound having a naphthalene moiety. As specific, non-limiting examples, a blue EML can be formed by doping IDE105 (product name, produced by ldemitz Co.) that acts as a dopant on IDE140 (product name, produced by Idemitz Co.). However, the method of forming the blue EML is not limited there to the above method.

The thickness of the EML may be in the range from 200 Å to 500 Å (20nm to 50nm), or more specifically, from 300 Å to 400 Å (30nm to 40nm). Meanwhile, EMLs of R, G, and B colors may have the same thickness as each other or different thicknesses from each other. When the thickness of the EML is less than 200 Å (20nm), the lifetime of the organic light emitting device may be decreased. On the other hand, when the thickness of the EML is greater than 500 Å (50nm), the operation voltage of the organic light emitting device may be increased.

The EML can be formed using various known methods including a vacuum deposition method, a spin coating method, a casting method, or an LB method. When the EML is formed using a vacuum deposition method or a spin coating method, the deposition conditions and the coating conditions may vary according to the type of compound used. In general, however, the deposition conditions and the coating conditions may be similar to the deposition and the coating conditions to form the HIL.

A hole blocking layer (HBL) (not shown) can be selectively formed on the EML using a vacuum deposition method or a spin coating method. The material used to form the HBL is not limited, and can be any material that has an electron transporting capability and a higher ionization potential than the light emitting compound. For example, the material used to form the HBL can be bis(2-methyl-8-quinolato)- (p-phenylphenolato)-aluminum (Balq), bathocuproine(BCP), or tris(N-aryl benzimidazole)(TPBI).

The thickness of the HBL may be in the range from 30 Å to 60 Å (3nm to 6nm), or more specifically, from 40 Å to 50 Å (4nm to 5nm). When the thickness of the HBL is less than 30 Å (3nm), hole blocking properties may not obtained. On the other hand, when the thickness of the HBL is greater than 50 Å (5nm), the operation voltage of the organic light emitting device may be increased.

The HBL can be formed using various known methods including a vacuum deposition method, a spin coating method, a casting method, or an LB method. When the HBL is formed using a vacuum deposition method or a spin coating method, the deposition conditions and the coating conditions may vary according to the type of compound used. In general, however, the deposition conditions and the coating conditions may be similar to the deposition and the coating conditions to form the HIL.

An ETL can be selectively formed on the EML or the HBL by vacuum depositing or spin coating an electron transporting material. The electron transporting material is not limited, and can be Alq3, for example.

The thickness of the ETL may be in the range from 100 Å to 400 Å (10nm to 40nm), or more specifically, from 250 Å to 350 Å (25nm to 35nm). When the thickness of the ETL is less than 100 Å (10nm), electrons may be transported too quickly, and a charge balance may be broken. On the other hand, when the thickness of the ETL is greater than 400 Å (40nm), the operation voltage of the organic light emitting device may be increased.

The ETL can be formed using various known methods including a vacuum deposition method, a spin coating method, a casting method, or an LB method. When the ETL is formed using a vacuum deposition method or a spin coating method, the deposition conditions and the coating conditions may vary according to the type of compound used. In general, however, the deposition conditions and the coating conditions may be similar to the deposition and the coating conditions to form the HIL.

The EIL can be formed on the EML, the HBL, or the ETL using a vacuum deposition method or a spin coating method. The material used to form the EIL can be BaF₂, LiF, NaCl, CsF, Li₂O, BaO, or lithium quinolate (Liq), as non-limiting examples, but is not limited thereto.

The thickness of the EIL may be in the range from 2 Å to 10 Å (0.2nm to 1 nm), or more specifically, from 2 Å to 5 Å (0.2nm to 0.5nm), or even more specifically, from 2 Å to 4 Å (0.2nm to 0.4nm). When the thickness of the EIL is less than 2 Å (0.2nm), the electron injecting properties may be decreased. On the other hand, when the thickness of the EIL is greater than 10 Å (1 nm), the operation voltage of the organic light emitting device may be increased.

The EIL can be formed using various known methods including a vacuum deposition method, a spin coating method, a casting method, or an LB method. When the EIL is formed using a vacuum deposition method or a spin coating method, the deposition conditions and the coating conditions may vary according to the type of compound used. In general, however, the deposition conditions and the coating conditions may be similar to the deposition and the coating conditions to form the HIL.

Then, a material used to form the second electrode is deposited on the EIL to form the second electrode. Therefore, the fabrication process of an organic light emitting device is completed. The material used to form the second electrode can be a transparent metal having an excellent conductivity, such as indium tin oxide (ITO), indium zinc oxide (IZO), tin oxide (SnO₂), zinc oxide (ZnO), lithium (Li), or magnesium (Mg). The material used to form the second electrode can also be aluminum (Al), aluminum-lithium (Al-Li), potassium (Ca), magnesium-indium (Mg-In), magnesium-silver (Mg-Ag), or potassium (Ca)-aluminum (Al) to obtain a reflective electrode, a semitransparent electrode, or a transparent electrode. The material used to form the second electrode is not limited to these metals or a combination of these metals.

The first electrode and the second electrode can be an anode and a cathode, respectively. Alternatively, the first electrode and the second electrode can be a cathode and an anode, respectively.

A preferred embodiment of the present invention will be described in further detail with reference to the following examples. These examples are for illustrative purposes only and are not intended to limit the scope of the present invention.

### Example

A Corning 150/cm² (1200Å (120nm)) ITO glass substrate was cut to a size of 50mm × 50mm × 0.7mm, and then washed with ultrasonic waves in isopropyl alcohol for five minutes and also in pure water for five minutes. Then, ultraviolet rays were irradiated onto the washed substrate for 30 minutes and then the resultant substrate was exposed to ozone. The resultant glass substrate was then installed in a vacuum disposition apparatus, and an anode was formed on the substrate.

Molybdenum oxide and NPB were co-deposited to a thickness of 50 Å (5nm) on the anode to form a first HTL. Then, a second HIL was formed on the first HIL using TCTA.

Then, 4,4'-bis[N-(1-naphthyl)-N- phenylamino]biphenyl (NPB), which is a hole transporting compound, was vacuum deposited to a thickness of 300 Å (30nm) to form an HTL.

Then, DPVBi, which is a known blue fluorescent light emitting material, was deposited to a thickness of 200 Å (20nm) on the HTL to form an EML.

Then, Alq₃ was deposited to a thickness of 300 Å (30nm) on the EML to form an ETL, and then, LiF, which is a halogenated alkali metal, was deposited to a thickness of 10 Å (10nm) on the ETL to form an EIL. Al was deposited to a thickness of 3000 Å(300nm) to form an LiF/Al electrode. Therefore, an organic light emitting device was fabricated.

### Comparative Example

An organic light emitting device was fabricated in the same manner as in the Example, except that an HIL was formed to a single layer using IDE406 (produced by Idemitz Co.).

### Assessment Example

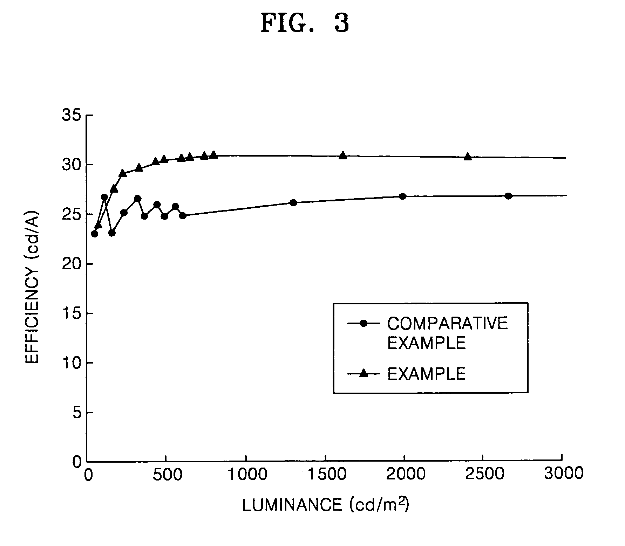

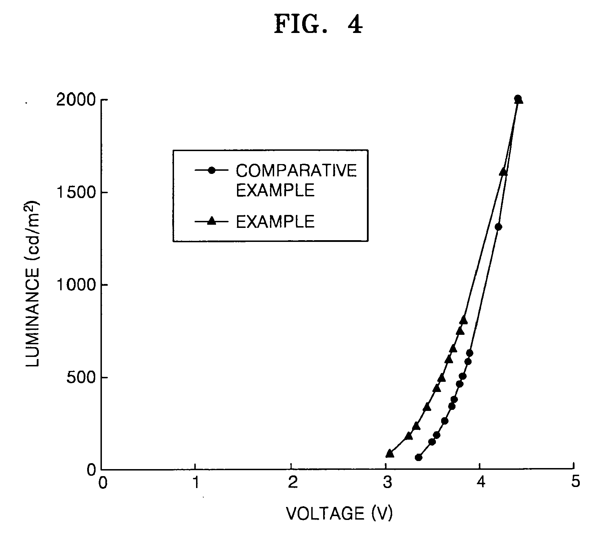

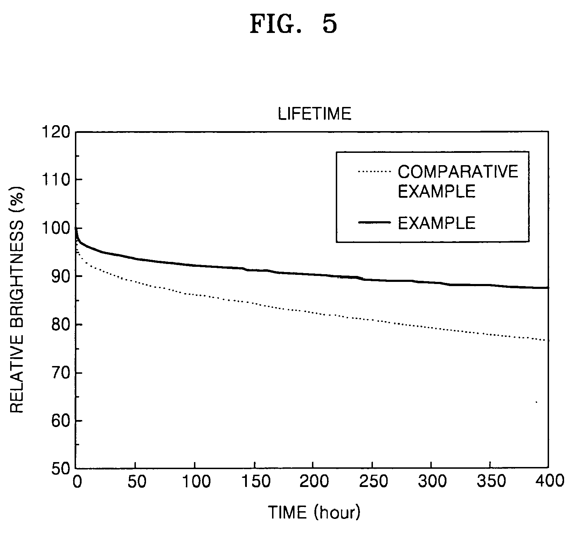

Current-voltage properties and brightness-voltage properties of organic light emitting devices prepared according to the Example and the Comparative Example were measured. Comparative results of the respective measurements are shown in FIGS. 3 and 4. FIG. 5 is a graph of brightness with respect to time of the organic light emitting devices of the Example and the Comparative Example. The efficiency was measured using PR650 (Photo Research Inc.), and current-voltage properties were measured using a Keithley model 236 source-measure unit (SMU).

As a result, it can be seen that when a material for an HIL according to a preferred embodiment is used, the operation voltage at the same current value is decreased due to the high charge injection capability, the current efficiency is increased, the brightness is increased due to such a high current efficiency, and also the lifetime is increased.

As described above, the material for an HIL has excellent electrical properties, and is suitable for fluorescent and phosphorescent light emitting devices emitting light of a full range of colors, such as red, green, blue, or white. Therefore, an organic light emitting device including the materials to form a hole injection layer according to the preferred embodiment of the present invention exhibits high efficiency and high luminance at low voltage, and has a long lifetime.

Although a few embodiments of the present invention have been shown and described, it would be appreciated by those skilled in the art that changes may be made in this embodiment without departing from the principles of the invention, the scope of which is defined in the claims and their equivalents.

## Claims

1. An organic light emitting device comprising:
a first electrode;
a second electrode;
an emitting layer interposed between the first electrode and the second electrode; and
a hole injection layer interposed between the first electrode and the emitting layer, wherein the hole injection layer comprises:
a first compound having an element selected from the group consisting of Mo, Li, Na, K, Rb, Cs, Be, Mg, Ca, Sr, Ba, and B and an element selected from the group consisting of O, F, S, Cl, Se, Br, and I; and
a second compound that is an organic hole injection layer forming compound.

2. An organic light emitting device according to claim 1, wherein the second compound is selected from the group consisting of copper phthalocyanine, 1,3,5-tricarbazolylbenzene, 4,4'-biscarbazolylbiphenyl, polyvinylcarbazole, m-biscarbazolylphenyl, 4,4'-biscarbazolyl-2,2'-dimethylbiphenyl, 4,4',4"-tri(N-carbazolyl)triphenylamine (TCTA), 4,4',4"-tris(3-methylphenylamino)triphenylamine(m-MTDATA), 1,3,5-tri(2-carbazolylphenyl)benzene, 1,3,5-tris(2-carbazolyl-5-methoxyphenyl)benzene, bis(4-carbazolylphenyl)silane, N,N'-bis(3-methylphenyl)-N,N'-diphenyl-[1,1-biphenyl]-4,4'diamine (TPD), N,N'-di(naphthalene-1-yl)-N,N'-diphenyl benzidine (α-NPD), N,N'-diphenyl-N,N'-bis(1-naphthyl)-(1,1'-biphenyl)-4,4'-diamine (NPB), poly(9,9-dioctylfluorene-co-N-(4-butylphenyl)diphenylamine) (TFB), and poly(9,9-dioctylfluorene-co-bis-N,N-phenyl-1,4-phenylenediamine (PFB).

3. An organic light emitting device according to claim 1 or claim 2 , wherein the mixture ratio of the first compound and the second compound is in the range from 1:1 to 3:1.

4. An organic light emitting device according to claim 1, 2 or 3 wherein the first compound is selected from the group consisting of molybdenum oxide, magnesium fluoride, magnesium oxide, lithium fluoride, sodium fluoride, calcium oxide, cesium fluoride, boron oxide, strontium oxide, and barium oxide.

5. An organic light emitting device according to any preceding claim, further comprising at least one layer selected from the group consisting of a hole injection layer, a hole transport layer, an electron blocking layer, an emitting layer, a hole blocking layer, an electron transport layer, and an electron injection layer.

6. An organic light emitting device according to any preceding claim , wherein the organic light emitting device has one of the following structures:
first electrode/hole injection layer/hole transport layer/emitting layer/electron transport layer/second electrode;
first electrode/hole injection layer/hole transport layer/emitting layer/electron transport layer/electron injection layer/second electrode; or
first electrode/hole injection layer/hole transport layer/emitting layer/hole blocking layer/electron transport layer/electron injection layer/second electrode.

7. An organic light emitting device according to any of claims 1 to 5 further comprising a second hole injection layer between the first hole injection layer and the emitting layer.

8. An organic light emitting device according to claim 7, wherein the thickness ratio of the first hole injection layer to the second hole injection layer is in the range from 1:99 to 1:9.

9. An organic light emitting device according to claim 7 or 8, wherein the second hole injection layer comprises at least one compound selected from the group consisting of copper phthalocyanine, 1,3,5-tricarbazolylbenzene, 4,4'-biscarbazolylbiphenyl, polyvinylcarbazole, m-biscarbazolylphenyl, 4,4'-biscarbazolyl-2,2'-dimethylbiphenyl, 4,4',4"-tri(N-carbazolyl)triphenylamine (TCTA), 4,4',4"-tris(3-methylphenylamino)triphenylamine(m-MTDATA), 1,3,5-tri(2-carbazolylphenyl)benzene, 1,3,5-tris(2-carbazolyl-5-methoxyphenyl)benzene, bis(4-carbazolylphenyl)silane, N,N'-bis(3-methylphenyl)-N,N'-diphenyl-[1,1-biphenyl]-4,4'diamine (TPD), N,N'-di(naphthalene-1-yl)-N,N'-diphenyl benzidine (α-NPD), N,N'-diphenyl-N,N'-bis(1-naphthyl)-(1,1'-biphenyl)-4,4'-diamine (NPB), poly(9,9-dioctylfluorene-co-N-(4-butylphenyl)diphenylamine) (TFB), and poly(9,9-dioctylfluorene-co-bis-N,N-phenyl-1,4-phenylenediamine (PFB) and wherein the second hole injection layer does not contain the first compound.

10. An organic light emitting device according to claim 7, 8 or 9 wherein the organic light emitting device has one of the following structures:
first electrode/first hole injection layer/second hole injection layer/hole transport layer/emitting layer/electron transport layer/second electrode;
first electrode/first hole injection layer/second hole injection layer/hole transport layer/emitting layer/electron transport layer/electron injection layer/second electrode; or
first electrode/first hole injection layer/second hole injection layer/hole transport layer/emitting layer/hole blocking layer/electron transport layer/electron injection layer/second electrode.
